# EUROPEAN PATENT APPLICATION

(11) **EP 3 734 843 A1**
(43) Date of publication of application: **04.11.2020**
(21) Application number: 20171948.1
(22) Date of filing: 28.04.2020
(51) Int. Cl.: H04B 1/04, H03H 7/40

(54) **RF AMPLIFIER HAVING A TUNABLE ANTENNA CIRCUIT**

(30) Priority: 03.05.2019 US 201962843137 P; 14.04.2020 US 202016848627
(71) Applicant: Honeywell International Inc., Morris Plains, NJ 07950 (US)
(72) Inventor: BACKES, Glen Brian, Golden Valley, Minnesota 55422 (US); LARSON, Christian Kenneth, Morris Plains, NJ New Jersey 07950 (US); BECKER, Robert Charles, Morris Plains, NJ New Jersey 07950 (US)
(74) Representative: Dennemeyer & Associates S.A.

(57) **Abstract**

A circuit and computer implemented method tunes an RF switching power amplifier circuit for an antenna by receiving a measurement of reflected RF signal from the antenna, receiving a measurement of current provided to the circuit from a power source, receiving a measurement of RF power provided to the antenna, adjusting a tunable antenna circuit responsive to the measurement of reflected RF signal, and adjusting a first capacitor capacitance value and a second capacitor capacitance value of a waveform shaping circuit in response to the received measurement of current and RF power.

## Description

### BACKGROUND

Wireless devices, such as Internet of Things (IOT) devices may be battery powered. Many wireless IOT devices are sensors that are designed to transmit signals containing information representative of a parameter that they sense, such as temperature, pressure, sound, images, battery condition, or other parameters. The information is generally transmitted at a selected radio frequency (RF), which may quickly deplete the energy stored in a battery, leading to a need to frequently replace batteries in wireless devices.

### SUMMARY

The efficiency of an RF transmitter, specifically switch-mode amplifier topologies such as Class-E amplifiers and other amplifiers is improved by automatically tuning an antenna tuning circuit to match complex impedances encountered by an antenna, and also by tuning a wave-forming circuit of the switch-mode amplifier. The dual tuning reduces power consumption and lengthens battery life in battery operated electronic devices by efficiently optimizing the transmitted power output power under variable antenna loading.

### BRIEF DESCRIPTION OF THE DRAWINGS

FIG. 1 is a circuit diagram of a power amplifier with a tunable antenna circuit according to an example embodiment.
FIG. 2 is a flowchart illustrating a computer/processor implemented method of tuning the power amplifier circuit according to an example embodiment.
FIG. 3 is a lookup table used by an algorithm to select capacitance values to tune the power amplifier circuit according to an example embodiment.
FIG. 4 is a block schematic diagram of a computer system to implement one or more example embodiments.

### DETAILED DESCRIPTION

In the following description, reference is made to the accompanying drawings that form a part hereof, and in which is shown by way of illustration specific embodiments which may be practiced. These embodiments are described in sufficient detail to enable those skilled in the art to practice the invention, and it is to be understood that other embodiments may be utilized and that structural, logical and electrical changes may be made without departing from the scope of the present invention. The following description of example embodiments is, therefore, not to be taken in a limited sense, and the scope of the present invention is defined by the appended claims.

The functions or algorithms described herein may be implemented in software in one embodiment. The software may consist of computer executable instructions stored on computer readable media or computer readable storage device such as one or more non-transitory memories or other type of hardware-based storage devices, either local or networked. Further, such functions correspond to modules, which may be software, hardware, firmware or any combination thereof. Multiple functions may be performed in one or more modules as desired, and the embodiments described are merely examples. The software may be executed on a digital signal processor, ASIC, microprocessor, or other type of processor operating on a computer system, such as a personal computer, server or other computer system, turning such computer system into a specifically programmed machine.

The functionality can be configured to perform an operation using, for instance, software, hardware, firmware, or the like. For example, the phrase "configured to" can refer to a logic circuit structure of a hardware element that is to implement the associated functionality. The phrase "configured to" can also refer to a logic circuit structure of a hardware element that is to implement the coding design of associated functionality of firmware or software. The term "module" refers to a structural element that can be implemented using any suitable hardware (e.g., a processor, among others), software (e.g., an application, among others), firmware, or any combination of hardware, software, and firmware. The term, "logic" encompasses any functionality for performing a task. For instance, each operation illustrated in the flowcharts corresponds to logic for performing that operation. An operation can be performed using, software, hardware, firmware, or the like. The terms, "component," "system," and the like may refer to computer-related entities, hardware, and software in execution, firmware, or combination thereof. A component may be a process running on a processor, an object, an executable, a program, a function, a subroutine, a computer, or a combination of software and hardware. The term, "processor," may refer to a hardware component, such as a processing unit of a computer system.

Furthermore, the claimed subject matter may be implemented as a method, apparatus, or article of manufacture using standard programming and engineering techniques to produce software, firmware, hardware, or any combination thereof to control a computing device to implement the disclosed subject matter. The term, "article of manufacture," as used herein is intended to encompass a computer program accessible from any computer-readable storage device or media. Computer-readable storage media can include, but are not limited to, magnetic storage devices, e.g., hard disk, floppy disk, magnetic strips, optical disk, compact disk (CD), digital versatile disk (DVD), smart cards, flash memory devices, among others. In contrast, computer-readable media, i.e., not storage media, may additionally include communication media such as transmission media for wireless signals and the like.

Power amplifiers are used in a variety of applications to provide power to a load, such as an antenna. Class-E/F amplifiers are highly efficient tuned switching power amplifiers used at radio frequencies. Such amplifiers use a single-pole switching element and a tuned reactive network between the switch and the load. The circuit obtains high efficiency by only operating the switching element at points of zero current (on to off switching) or zero voltage (off to on switching) which minimizes power lost in the switch, even when the switching time of the devices is long compared to the frequency of operation.

Overcoming RF link budget constraints and battery life are dominant challenges for proper operation of wireless devices, such as IOT devices. Compounding this problem further, most RF devices are susceptible to antenna performance degradation due to the proximity of the hand, head, or other objects which may be held close to the radiating antenna. This antenna degradation can severely limit the effective range of communication, and in the case of devices with automatic level control, limit battery life due to excessive power consumption of the power amplifier. This detuning effect is particularly pronounced on electrically small, high Q antennas that have narrow bandwidths. The amount of detuning is typically highly arbitrary and is difficult to pre-tune in the development/production process due to the wide range of detuning variance.

Various embodiments of the present inventive subject matter improve the efficiency of an RF transmitter, specifically switch-mode amplifier topologies such as Class-E amplifiers and other amplifiers. This is accomplished by automatically tuning an antenna tuning circuit to match complex impedances and also by tuning a wave-forming circuit of the switch-mode amplifier. The dual tuning reduces power consumption increasing battery life in battery operated electronic devices by efficiently optimizing the transmitted power output power under variable antenna loading, and also optimizing the DC to RF efficiency of the amplifier circuit under antenna loading. Dual automatically tunable circuits work in conjunction with each other to optimize the RF output power and battery life.

One benefit of power amplifier 100 is the provision of higher RF power for increased communication distances and longer battery life when compared to devices without the dual tuning circuitry.

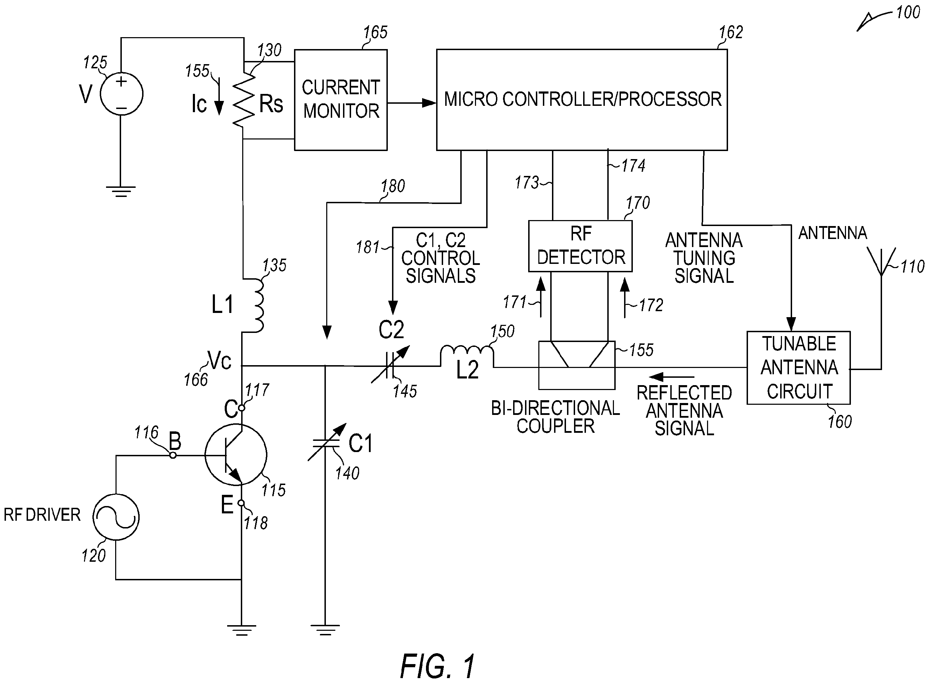

FIG. 1 is a circuit diagram of a power amplifier 100 with a tunable antenna circuit according to an example embodiment. In one embodiment, the power amplifier 100 has a Class-E amplifier topology. Additional components are added to allow automatic tuning of the antenna and tuning of an output waveform shaping circuit.

Amplifier 100 includes an antenna 110 as a load that is driven by RF power. A transistor 115 has a gate/base 116 that is coupled to an RF driver 120 that provides an RF input. In various embodiments, transistor 115 may be JFET, MOSFET, or Bipolar transistor and serves as an active device. Transistor 115 has a collector 117 that is also coupled to receive current from a DC power source 125 via a resistor Rs 130 and series coupled inductor L1. Inductor L1 may operate as an RF choke to block higher frequencies. An emitter 118 of transistor 115 is coupled to ground. The transistor 115 is also coupled in parallel with a capacitor C1 140 between the transistor collector 117 and ground. The transistor collector 117 is also coupled to a second capacitor C2 145, inductor L2 150, bi-directional coupler 155, and tunable antenna circuit 160 in series with the antenna 110 to drive the antenna 110 with amplified RF signals.

A processor 162 is coupled to receive multiple signals from different portions of the power amplifier 100 circuit. Processor 162 may be a programmed microcontroller, microprocessor, or other circuitry configured to provide control actions based on information received regarding sensed parameters as described below. A current monitor 165 is coupled to measure and provide information to processor 162 representative of current Ic 155 through resistor Rs 130. An RF detector 170 is coupled to bi-directional coupler 155 to receive a forward amplified signal 171 and a reflected antenna signal 172, detect the respective levels of the received signals, and provide information representative of the received signals to the processor 162 on conductors 173 and 174 respectively. The forward amplified signal 171 is a measure of the power output of the power amplifier 100. The reflected signal is a measure of the impedance matching of the antenna with circuitry and impedance of the environment in which the antenna is placed.

The processor 162 uses the received information to adjust one or more circuit elements. The tunable antenna circuit 160 receive an antenna tuning signal 180 from processor 162 to match complex impedances seen by the tunable antenna circuit 160. Similarly, processor 162 adjusts the capacitances of C1 140 and C2 145 via control signals indicated at 180 and 181 respectively to increase efficiency of energy utilization.

L2 150 and C2 145 form a resonant circuit acting as a bandpass filter. The combination of C1 140, C2 145, L1 135, and L2 150 provide an output waveform circuit that operates to shape the collector current (Ic) 155 and the collector voltage (Vc) 156, referred to as active device parameters, such that one parameter is zero when the other parameter has a finite positive value. Since the power dissipated = Ic x Vc, this will equal zero since either Ic or Vc is zero when the other has a non-zero value. Higher efficiency is achieved as the power dissipation decreases.

The optimal values for C1, C2, L1, and L2 depend on the load (antenna 110) impedance. Ideally, the antenna auto-tuning circuit, tunable antenna circuit 160, will provide a perfect match (50 real Ohms) to the amplifier output, but this will not always be the case in a real-world circuit. As a result, the amplifier will see a complex load impedance not equal to 50 Ohms which will (1) reduce the efficiency of the amplifier and (2) reduce the power output of the amplifier.

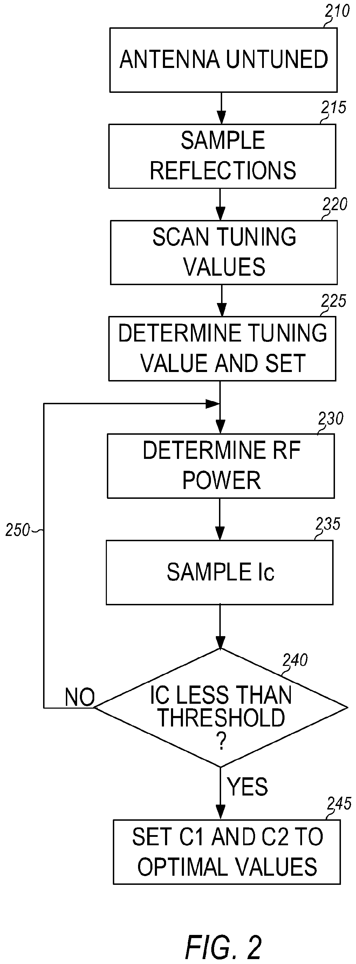

FIG. 2 is a flowchart illustrating a computer/processor implemented method 200 of tuning the power amplifier circuit 100. Method 200 includes the flow of tuning operations or actions taken by the controller 162 to optimize the power output and DC to RF efficiency. The tuning actions may be taken each time a device is scheduled to transmit data. The transmission may occur periodically, such as every 10 seconds. Some devices may transmit more often, such as every second or less, while others may transmit less often, such as once per minute, hour, day, week, etc., depending on the function that the device is performing and how often data from the device is desired. If the period is very short, the actions may be taken less frequently than every time a device is scheduled to transmit data. The frequency of taking the actions may be varied based on expected instability of antenna loading.

At 210, due to inadvertent antenna 110 loading, the antenna 110 becomes untuned and causes reflections. The reflections are sampled at 215 by the bi-directional coupler 155, detector 170, and A to D (analog to digital) converted in the processor 162 or prior to being received by the processor 162. At 220, tuning values are scanned by the tunable antenna circuit 160 under control of processor 162. The values usually scanned are capacitance values. Inductance values could alternatively be scanned, but in practice, tunable inductors are difficult to find and/or create. The word scanning in this context means incrementing the capacitance or inductance value, taking a measurement, then incrementing the value, taking another measurement, and repeating. The tunable capacitor or inductor is typically electronically tuned by means of a control voltage or control current from the microcontroller.

The optimal value is determined at 225 by identifying the minimum reflection and associated values. In response, the circuit 160 is programmed to that value.

The RF power of the amplifier is sampled and measured in the forward path of the directional coupler, detector, and A to D converter in the microprocessor at 230. The measurement of the forward power and current (Ic) is a function of the capacitance values. As the capacitance values are incremented, the measured power and current are temporarily stored in memory for each set of capacitance values. After the data is taken, the microcontroller determines the ideal set of values for proper power and current and sets the capacitors to those values.

At 235, the DC current Ic is sampled and measured with the current monitor 165 and A to D converter of the microprocessor. Rs is a very small resistance in which to measure a small voltage drop which is used by the current monitor.

At 240, a determination is made if the values for C1 and C2 are result in a current Ic that is less than a preset threshold Ic. If yes, the values are deemed optimal and the optimal set of values for C1 and C2 are set and held for a pre-determined RF transmission time frame at operation 245.

If no, at 250, an iterative and adaptive tuning algorithm may be used to vary C1 and C2 to optimize to a pre-programmed set of parameters of forward RF power and Ic. There is an ideal efficiency and power level that is specific to each application. For example, for a battery-operated device, power that is too high would reduce the battery life. FCC emissions limitations may be violated for too high of power. Too low of power, on the other hand, would limit RF link budget. Samples of forward RF power and Ic are taken at every measurement to determine the efficacy that the values have on circuit performance.

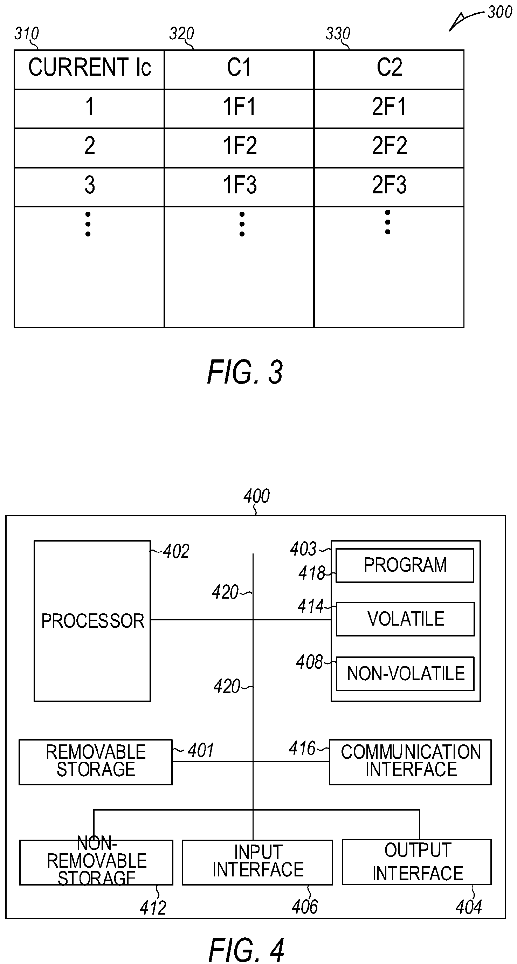

In one embodiment, various sets of values for C1 and C2 for corresponding currents Ic may be stored in a lookup table as shown in FIG. 3 at 300. The currents are represented by integers in column 310, as the actual currents may vary for power amplifiers 100 have different values for the circuit elements therein. Similarly, the values for the capacitors in columns 320 and 330 are represented as 1F1, 1F2, 1F3 for C1 and 2F1, 2F2, 2F3 for C2, where F represents Farads or microfarads. Note that if the measured current is below a threshold preset value, no adjustments need be made, and method 200 ends.

The tuning algorithm may use a first set of values, measure the current, use the current as an index into the table 300 and select the set of values corresponding to that current and also corresponding to a lower power level. Several cycles of measuring and resetting capacitor values may be used to arrive at the optimal set of values.

In one embodiment, there may be a set of 32x32 values for 32 different current levels for 1024 different combinations of values. In one embodiment, the different combinations values are tried sequentially until the measured current is below the threshold current. The combination of values is deemed optimal.

FIG. 4 is a block schematic diagram of a computer system 400 to implement processor 162 and for performing methods and algorithms according to example embodiments. All components need not be used in various embodiments.

One example computing device in the form of a computer 400 may include a processing unit 402, memory 403, removable storage 410, and non-removable storage 412. Although the example computing device is illustrated and described as computer 400, the computing device may be in different forms in different embodiments. For example, the computing device may instead be a smartphone, a tablet, smartwatch, smart storage device (SSD), or other computing device including the same or similar elements as illustrated and described with regard to FIG. 4. Devices, such as smartphones, tablets, and smartwatches, are generally collectively referred to as mobile devices or user equipment.

Although the various data storage elements are illustrated as part of the computer 400, the storage may also or alternatively include cloud-based storage accessible via a network, such as the Internet or server-based storage. Note also that an SSD may include a processor on which the parser may be run, allowing transfer of parsed, filtered data through I/O channels between the SSD and main memory.

Memory 403 may include volatile memory 414 and non-volatile memory 408. Computer 400 may include - or have access to a computing environment that includes - a variety of computer-readable media, such as volatile memory 414 and non-volatile memory 408, removable storage 410 and non-removable storage 412. Computer storage includes random access memory (RAM), read only memory (ROM), erasable programmable read-only memory (EPROM) or electrically erasable programmable read-only memory (EEPROM), flash memory or other memory technologies, compact disc read-only memory (CD ROM), Digital Versatile Disks (DVD) or other optical disk storage, magnetic cassettes, magnetic tape, magnetic disk storage or other magnetic storage devices, or any other medium capable of storing computer-readable instructions.

Computer 400 may include or have access to a computing environment that includes input interface 406, output interface 404, and a communication interface 416. Output interface 404 may include a display device, such as a touchscreen, that also may serve as an input device. The input interface 406 may include one or more of a touchscreen, touchpad, mouse, keyboard, camera, one or more device-specific buttons, one or more sensors integrated within or coupled via wired or wireless data connections to the computer 400, and other input devices. The computer may operate in a networked environment using a communication connection to connect to one or more remote computers, such as database servers. The remote computer may include a personal computer (PC), server, router, network PC, a peer device or other common data flow network switch, or the like. The communication connection may include a Local Area Network (LAN), a Wide Area Network (WAN), cellular, Wi-Fi, Bluetooth, or other networks. According to one embodiment, the various components of computer 400 are connected with a system bus 420.

Computer-readable instructions stored on a computer-readable medium are executable by the processing unit 402 of the computer 400, such as a program 418. The program 418 in some embodiments comprises software to implement one or more algorithms and methods for tuning described herein. A hard drive, CD-ROM, and RAM are some examples of articles including a non-transitory computer-readable medium such as a storage device. The terms computer-readable medium and storage device do not include carrier waves to the extent carrier waves are deemed too transitory. Storage can also include networked storage, such as a storage area network (SAN). Computer program 418 along with the workspace manager 422 may be used to cause processing unit 402 to perform one or more methods or algorithms described herein.

### Examples:

1. A computer implemented method of tuning an RF switching power amplifier circuit for an antenna includes receiving a measurement of reflected RF signal from the antenna, receiving a measurement of current provided to the circuit from a power source, receiving a measurement of RF power provided to the antenna, adjusting a tunable antenna circuit responsive to the measurement of reflected RF signal, and adjusting a first capacitor capacitance value and a second capacitor capacitance value of a waveform shaping circuit in response to the received measurement of current and RF power.
2. The method of example 1 wherein the capacitance values are adjusted in response to the received measurement of current being above a preset current threshold.
3. The method of any of examples 1-2 wherein the measurement of current is provided by a current monitor coupled across a resistor in a current path between the power source and a collector of an active device.
4. The method of example 3 wherein the active device includes a base driven by an RF driver, and wherein the collector is coupled to ground via the first capacitor and is coupled to the antenna via the second capacitor.
5. The method of any of examples 1-4 wherein the capacitance values are adjusted as a function of a capacitance value table having multiple different pairs of capacitance values for the first and second capacitors.
6. The method of any of examples 1-5 wherein adjusting a first capacitor capacitance value and a second capacitor capacitance value of a waveform shaping circuit in response to the received measurement of current and RF power further includes comparing the received measurement of current to preset current threshold, setting the capacitance values to current capacitance values in response to the received measurement of current being less than the preset current threshold, and repeating the measuring of the current and RF power and adjusting capacitance values until the received measurement of current is less than the preset current threshold.
7. The method of any of examples 1-6 wherein adjusting a tunable antenna circuit responsive to the measurement of reflected RF signal is performed by scanning tuning values to minimize the measurement of reflected RF signal from the antenna.
8. The method of any of examples 1-7 and further comprising transmitting data via the RF switching power amplifier circuit and antenna following tuning of both the tunable antenna circuit and the waveform shaping circuit.
9. A circuit for driving an antenna to periodically transmit data includes a current monitor to measure current provided by a power source, an active device having a first input coupled to receive current provided by the power source and having a second input coupled to receive an RF driver signal. The active device is configured to amplify the RF driver signal. An output waveform shaping circuit is coupled to receive the amplified RF driver signal from the first input of the active device, the output waveform shaping device including a first adjustable capacitor coupled to ground and a second adjustable capacitor coupled to provide the amplified RF driver signal to an antenna and, and a first inductor coupled in series with the second capacitor to form a resonant circuit. A bi-directional coupler and a tunable antenna circuit are coupled in series with the resonant circuit and the antenna. An RF detector is coupled to detect reflected antenna signals and the amplified RF driver signal, and a controller is coupled to adjust the tunable antenna circuit to minimize reflected antenna signals and to adjust the first and second capacitance values in response to the measured current and detected amplified RF driver signal.
10. The circuit of example 9 and further comprising a choke inductor coupled between the power source and the active device.
11. The circuit of any of examples 9-10 wherein the active device comprises a transistor where the first input comprises a collector and the second input comprises a base.
12. The circuit of any of examples 9-11 wherein the current monitor comprises a resister coupled in series with the active device and the power source and sized to cause a minimal voltage drop, wherein the current monitor measures the voltage drop across the resistor to determine the current.
13. The circuit of any of examples 9-12 wherein the controller is configured to perform operations to adjust the tunable antenna circuit and adjust the first and second capacitance values. The operations include receiving a measurement of reflected RF signal from the antenna, receiving a measurement of current provided to the circuit from a power source, receiving a measurement of RF power provided to the antenna, adjusting a tunable antenna circuit responsive to the measurement of reflected RF signal, and adjusting a first capacitor capacitance value and a second capacitor capacitance value of a waveform shaping circuit in response to the received measurement of current and RF power.
14. The circuit of example 13 wherein the capacitance values are adjusted in response to the received measurement of current being above a preset current threshold.
15. The circuit of any of examples 13-14 wherein the measurement of current is provided by a current monitor coupled across a resistor in a current path between the power source and a collector of an active device.
16. The circuit of example 15 wherein the active device includes a base driven by an RF driver, and wherein the collector is coupled to ground via the first capacitor and is coupled to the antenna via the second capacitor.
17. The circuit of any of examples 13-16 wherein the capacitance values are adjusted as a function of a capacitance value table having multiple different pairs of capacitance values for the first and second capacitors.
18. The circuit of any of examples 13-17 wherein adjusting a first capacitor capacitance value and a second capacitor capacitance value of a waveform shaping circuit in response to the received measurement of current and RF power further includes comparing the received measurement of current to preset current threshold, setting the capacitance values to current capacitance values in response to the received measurement of current being less than the preset current threshold, and repeating the measuring of the current and RF power and adjusting capacitance values until the received measurement of current is less than the preset current threshold.
19. The circuit of any of examples 13-18 wherein adjusting a tunable antenna circuit responsive to the measurement of reflected RF signal is performed by scanning tuning values to minimize the measurement of reflected RF signal from the antenna.
20. The circuit of any of examples 13-19 and further comprising transmitting data via the RF switching power amplifier circuit and antenna following tuning of both the tunable antenna circuit and the waveform shaping circuit.

Although a few embodiments have been described in detail above, other modifications are possible. For example, the logic flows depicted in the figures do not require the particular order shown, or sequential order, to achieve desirable results. Other steps may be provided, or steps may be eliminated, from the described flows, and other components may be added to, or removed from, the described systems. Other embodiments may be within the scope of the following claims.

The following statements are potential claims that may be converted to claims in a future application. No modification of the following statements should be allowed to affect the interpretation of claims which may be drafted when this provisional application is converted into a regular utility application.

## Claims

1. A computer implemented method of tuning an RF switching power amplifier circuit (100) for an antenna (110), the method comprising:
receiving a measurement (170, 215) of reflected RF signal (172) from the antenna;
receiving a measurement (165, 220) of current (155) provided to the circuit from a power source (125);
receiving a measurement of RF power (171, 220) provided to the antenna;
adjusting (225) a tunable antenna circuit (166) responsive to the measurement of reflected RF signal; and
adjusting a first capacitor capacitance value (140) and a second capacitor capacitance value (145) of a waveform shaping circuit (140, 145, 135, 150, 245) in response to the received measurement of current and RF power.

2. The method of claim 1 wherein the capacitance values are adjusted in response to the received measurement of current being above a preset current threshold (240).

3. The method of claim 1 wherein the measurement of current is provided by a current monitor (165) coupled across a resistor (130) in a current path between the power source and a collector (117) of an active device (115).

4. The method of claim 3 wherein the active device includes a base (116) driven by an RF driver (120), and wherein the collector is coupled to ground via the first capacitor (140) and is coupled to the antenna via the second capacitor (145).

5. The method of any one of claims 1-4 wherein the capacitance values are adjusted as a function of a capacitance value table (300) having multiple different pairs of capacitance values (320, 330) for the first and second capacitors.

6. The method of any one of claims 1-4 wherein adjusting a first capacitor capacitance value and a second capacitor capacitance value of a waveform shaping circuit in response to the received measurement of current and RF power further comprises:
comparing (240) the received measurement of current to preset current threshold;
setting (245) the capacitance values to current capacitance values in response to the received measurement of current being less than the preset current threshold; and
repeating (250) the measuring of the current and RF power and adjusting capacitance values until the received measurement of current is less than the preset current threshold.

7. The method of any one of claims 1-4 wherein adjusting the tunable antenna circuit responsive to the measurement of reflected RF signal is performed by scanning (220) tuning values to minimize the measurement of reflected RF signal from the antenna.

8. A circuit for driving an antenna to periodically transmit data, the circuit comprising:
a current monitor (165) to measure current provided by a power source;
an active device (115) having a first input (117) coupled to receive current provided by the power source and having a second input (116) coupled to receive an RF driver (120) signal, the active device configured to amplify the RF driver signal;
an output waveform shaping circuit(140, 145, 135, 150) coupled to receive the amplified RF driver signal from the first input of the active device, the output waveform shaping device including a first adjustable capacitor (140) coupled to ground and a second adjustable capacitor (145) coupled to provide the amplified RF driver signal to an antenna (110), the output waveform shaping circuit including a first inductor (150) coupled in series with the second capacitor to form a resonant circuit;
a bi-directional coupler (155) and a tunable antenna circuit (160) coupled in series with the resonant circuit and the antenna;
an RF detector (170) coupled to detect reflected antenna signals and the amplified RF driver signal; and
a controller (162) coupled to adjust the tunable antenna circuit to minimize reflected antenna signals and to adjust the first and second capacitance values in response to the measured current and detected amplified RF driver signal.

9. The circuit of claim 8 and further comprising a choke inductor (135) coupled between the power source (125) and the active device.

10. The circuit of claim 8 wherein the active device comprises a transistor where the first input comprises a collector and the second input comprises a base.

11. The circuit of claim 8 wherein the current monitor comprises a resister (130) coupled in series with the active device and the power source and sized to cause a minimal voltage drop, wherein the current monitor measures the voltage drop across the resistor to determine the current.

12. The circuit of any one of claims 8-11 wherein the controller is configured to perform operations to adjust the tunable antenna circuit and adjust the first and second capacitance values, the operations comprising:
receiving a measurement of reflected RF signal from the antenna;
receiving a measurement of current provided to the circuit from a power source;
receiving a measurement of RF power provided to the antenna;
adjusting a tunable antenna circuit responsive to the measurement of reflected RF signal; and
adjusting a first capacitor capacitance value and a second capacitor capacitance value of a waveform shaping circuit in response to the received measurement of current and RF power.

13. The circuit of claim 12 wherein the capacitance values are adjusted in response to the received measurement of current being above a preset current threshold, wherein the measurement of current is provided by a current monitor coupled across a resistor in a current path between the power source and a collector of an active device, wherein the active device includes a base driven by an RF driver, and wherein the collector is coupled to ground via the first capacitor and is coupled to the antenna via the second capacitor, and wherein the capacitance values are adjusted as a function of a capacitance value table having multiple different pairs of capacitance values for the first and second capacitors.

14. The circuit of claim 12 wherein adjusting a first capacitor capacitance value and a second capacitor capacitance value of a waveform shaping circuit in response to the received measurement of current and RF power further comprises:
comparing the received measurement of current to preset current threshold;
setting the capacitance values to current capacitance values in response to the received measurement of current being less than the preset current threshold; and
repeating the measuring of the current and RF power and adjusting capacitance values until the received measurement of current is less than the preset current threshold.

15. The circuit of claim 12 wherein adjusting a tunable antenna circuit responsive to the measurement of reflected RF signal is performed by scanning tuning values to minimize the measurement of reflected RF signal from the antenna.
